Europäisches Patentamt

European Patent Office

Office européen des brevets

(11) Veröffentlichungsnummer: **0 212 718**
**A2**

(12) # EUROPÄISCHE PATENTANMELDUNG

(21) Anmeldenummer: 86201302.6

(51) Int. Cl.⁴: **C23C 16/50**

(22) Anmeldetag: 23.07.86

(30) Priorität: 07.08.85 DE 3528275

(43) Veröffentlichungstag der Anmeldung:
04.03.87 Patentblatt 87/10

(84) Benannte Vertragsstaaten:
DE FR GB IT NL SE

(71) Anmelder: **Philips Patentverwaltung GmbH
Billstrasse 80
D-2000 Hamburg 28(DE)**
Anmelder: **N.V. Philips' Gloeilampenfabrieken
Groenewoudseweg 1
NL-5621 BA Eindhoven(NL)**

(72) Erfinder: **Geittner, Peter, Dr.
Hainbuchenstrasse 19A
D-5100 Aachen(DE)**
Erfinder: **Lydtin, Hans, Dr.
Am Goepelschacht 9
D-5190 Stolberg(DE)**
Erfinder: **Auwerda, Cornelis Petrus
Ericalaan 40
NL-5582 CA Waalre(NL)**

(74) Vertreter: **Piegler, Harald, Dipl.-Chem. et al
Philips Patentverwaltung GmbH Billstrasse
80 Postfach 10 51 49
D-2000 Hamburg 28(DE)**

(54) Verfahren und Vorrichtung zum Innenbeschichten von Rohren.

(57) Beim Innenbeschichten eines Rohres aus einem elektrisch isolierenden Material mit einem zweiten elektrisch isolierenden Material durch reaktive Abscheidung des zweiten elektrisch isolierenden Materials aus einem Gasgemisch, das durch das Rohr hindurchgeführt wird, wobei das Rohr erwärmt und die Abscheidung durch ein in dem Rohr hin-und herbewegtes, durch Mikrowellen erzeugtes Plasma aktiviert wird, wird ein niedriger Energieverbrauch dadurch erreicht, daß das Rohr zumindest teilweise durch die vom Plasma an die Rohrwand abgegebene Energie erwärmt und auf Reaktionstemperatur gehalten wird, indem die Wärmeverluste des Rohres an die Umgebung durch ein wärmereflektierendes Element auf die Rohrwand zurückgeführt werden.

FIG. 1

## Verfahren und Vorrichtung zum Innenbeschichten von Rohren

Die Erfindung betrifft ein Verfahren zum Innenbeschichten eines Rohres aus einem elektrisch isolierenden Material mit einem zweiten elektrisch isolierenden Material durch reaktive Abscheidung des zweiten elektrisch isolierenden Materials aus einem Gasgemisch, das durch das Rohr hindurchgeführt wird, wobei das Rohr thermisch erhitzt und die Abscheidung durch ein in dem Rohr hin-und herbewegtes, durch Mikrowellen erzeugtes Plasma aktiviert wird.

Ferner betrifft die Erfindung eine Vorrichtung zum Innenbeschichten eines Rohres aus einem elektrisch isolierenden Material mit einem zweiten elektrisch isolierenden Material durch reaktive Abscheidung des zweiten elektrisch isolierenden Materials aus einem Gasgemisch, das durch das Rohr hindurchgeführt wird, wobei die Vorrichtung ein Gaszufuhrsystem zum Zuführen des Gasgemisches zu dem Rohr, einen Mikrowellengenerator und einen Mikrowellenresonator zum Erzeugen und Aufrechterhalten eines Plasmas in dem Gasgemisch in dem Rohr, Mittel zum Hin-und Herbewegen des Plasmas in der Längsrichtung des Rohres und Mittel zum thermischen Erhitzen des Rohres enthält.

Ein Verfahren und eine Vorrichtung dieser Art sind u.a. aus Appl.Phys.Lett. 28 (1976) 645-646 und Topics in Current Chemistry 89 (1980) 107-131 bekannt. In diesen Literaturstellen ist die Herstellung von Lichtleitfasern nach dem PCVD-Verfahren beschrieben. Bei diesem Verfahren wird als zweites elektrisch isolierendes Material lichtführendes Material mit Hilfe des Plasmas aus dem flüchtige Ausgangsmaterialien enthaltenden Gasgemisch auf der Innenseite des Rohres, das entweder aus synthetisch hergestelltem oder aus aus Quarzkristallen durch Schmelzen hergestelltem amorphem Quarz (Schmelzkieselsäure, Quarzglas), der gegebenenfalls dotiert ist, besteht, oder das sowohl aus synthetisch hergestelltem als auch aus aus Quarzkristallen durch Schmelzen hergestelltem amorphem Quarz (Schmelzkieselsäure, Quarzglas), der gegebenenfalls dotiert ist, besteht, abgeschieden. Das Rohr wird, nachdem eine dem beabsichtigten Lichtleitfaseraufbau entsprechende Menge lichtführendes Material abgeschieden worden ist, zum Kollabieren gebracht, um eine massive Vorform zu bilden, von der Lichtleitfasern gezogen werden.

Wie in den angeführten Literaturstellen näher ausgeführt wird, sind für die Abscheidung haftender Schichten aus lichtführendem Material Temperaturen der Wand des Rohres zwischen 1100 und 1300°C erforderlich. Um dieser Temperaturen während der Beschichtung zu gewährleisten, werden Öfen als zusätzliche Energiequellen eingesetzt. Als Ausführungsformen kommen sowohl bewegliche Öfen, die synchron mit dem Mikrowellenresonator über dem zu beschichteten Rohr verschoben werden, als auch ein statischer Ofen, bei dem sich der gekühlte Mikrowellenresonator innerhalb eines Ofens über dem zu beschichtenden Rohr verschieben läßt, in Frage.

Obwohl mit beiden Ofenkonzepten innenbeschichtete Rohre hergestellt werden, die zu qualitativ hochwertigen Lichtleitfasern führen, sind beide Konzepte auch mit Nachteilen verknüpft. Nachteile dieser Öfen sind z.B. die aufwendige und teuere Konstruktion, der große Platzbedarf, die hohe träge Masse, die hohe thermische Trägheit und der hohe Energieverbrauch. Besonders störend an den bisherigen Konzepten erscheint, daß ein großer Teil der über das Plasma eingebrachten Prozeßwärme durch Kühlung und Abstrahlung verlorengeht, während gleichzeitig die von dem Resonator nicht abgedeckten Rohrteile zusätzlich erwärmt werden müssen.

Aufgabe der Erfindung ist es, ein Verfahren mit niedrigem Energieverbrauch und eine Vorrichtung einfacher Konstruktion anzugeben, womit die zuvor genannten Nachteile der bislang verwendeten Ofenkonzepte weitestgehend vermieden werden können.

Diese Aufgabe wird erfindungsgemäß dadurch gelöst, daß bei einem Verfahren der eingangs genannten Art das Rohr zumindest teilweise durch die vom Plasma an die Rohrwand abgegebene Energie erwärmt und auf Reaktionstemperatur gehalten wird, indem die Wärmeverluste des Rohres an die Umgebung durch ein wärmereflektierendes Element auf die Rohrwand zurückgeführt werden.

Ferner wird diese Aufgabe erfindungsgemäß dadurch gelöst, daß bei einer Vorrichtung der eingangs genannten Art die Mittel zum thermischen Erhitzen des Rohres ein wärmereflektierendes Element zum Zurückführen der durch das Plasma entstehenden und vom Rohr abgegebenen Wärme zum Rohr aufweisen.

Der vorliegenden Erfindung liegt der Gedanke zugrunde, die vom Plasma freigesetzte Energie nicht durch Kühlung und Abstrahlung abzuführen, sondern durch Reflektion der Wärmestrahlung im wesentlichen auf das Rohr zurückzubringen und damit eine weitgehend zeitlich und örtlich gleichmäßige Temperaturverteilung über der zu beschichtenden Rohrlänge mit nur geringfügiger oder ohne zusätzliche Energiezufuhr zu ermöglichen. Die Rückführung der vom Rohr abgestrahlten Energie, die im Wellenlängenbereich von > 2,8μm für

Quarz bei Temperaturen von etwa 1500 K etwa 40% der Strahlungsenergie eines schwarzen Körpers beträgt, erfolgt nach der Erfindung durch ein wärmereflektierendes Element.

Als wärmereflektierende Elemente sind insbesondere Wärmereflexionsfilteranordnungen geeignet, deren Reflexionsvermögen über einem möglichst großen Wellenlängenbereich für die vom Rohr bei Temperaturen von etwa 1300 bis 1600 K abgestrahlte Wärmeenergie hoch ist. Das wärmereflektierende Element besteht dabei aus mindestens einem Wärmereflexionsfilter.

Ein derartiges Wärmereflexionsfilter besteht aus einem Substrat aus einem hochtemperaturfesten Material, z.B. $SiO_2$, $Al_2O_3$ oder warmfeste Stähle, und einer darauf angebrachten Schicht aus einem wärmereflektierenden Material, z.B. Metalle, insbesondere Edelmetalle, $SnO_2$, oder $In_2O_3$. Derartige Materialzusammensetzungen des Reflexionsfilters haben den Vorteil, daß die im Betrieb auftretenden Temperaturen im Bereich bis etwa 1600 K weder das Substrat noch die Filterschicht nachteilig beeinflussen, wobei die wärmereflektierenden Materialien gleichzeitig mit hoher Ausbeute die bei 1300 bis 1600 K abgestrahlte Wärmeenergie reflektieren; das Substrat kann im Betrieb zusätzlich gekühlt werden.

Das Wärmereflexionsfilter weist vorzugsweise die Form eines mit wärmereflektierenden Materialien beschichteten Rohres auf, das konzentrisch zu dem Rohr aus elektrisch isolierendem Material angeordnet ist. Damit wird bewirkt, daß die vom Rohr abgestrahlte Wärmeenergie durch das Reflexionsfilter über dem Umfang gleichförmig auf das Rohr zurückreflektiert und demzufolge eine peripher homogene Temperaturverteilung erreicht wird.

In einer bevorzugten Ausführungsform ist die wärmereflektierende Beschichtung über der Rohrlänge und/oder über dem Rohrumfang nichtuniform aufgebracht. Damit wird erreicht, daß auch bei ungleichförmiger Wärmeabstrahlung des Rohres aus elektrisch isolierendem Material über der Rohrlänge und/oder über dem Umfang (verursacht etwa durch nichtuniforme Energieabgabe des bewegten Plasmas über Länge und/oder Umfang) dennoch gleichförmige Temperaturverteilungen auf dem Rohr erzeugt werden können, indem die nichtuniforme Energieabgabe durch die nichtuniformen Reflexions-Eigenschaften des Filterelements geeignet kompensiert wird.

Bei einer weiteren bevorzugten Ausführungsform der erfindungsgemäßen Vorrichtung sind mehrere mit wärmereflektierenden Materialien beschichtete Rohre konzentrisch übereinander angebracht und bezüglich ihrer axialen und/oder peripheren Position gegeneinander verschiebbar. Dies hat den Vorteil, daß das Reflexionsverhalten dieser Anordnung durch Verschiebung in axialer und/oder peripherer Richtung variabel und definiert verändert und damit die resultierenden Temperaturverteilungen auf dem Rohr aus elektrisch isolierendem Material definiert variiert werden können.

Vorzugsweise läßt sich die Erfindung mit drei verschiedenen Reflektor/Resonator/Rohr-Anordnungen realisieren:

Im ersten Fall sind die Wärmereflexionsfilter beidseitig an dem Mikrowellenresonator angebracht und mit diesem gemeinsam längs des Rohres aus elektrisch isolierendem Material hin und her bewegbar. Dies hat den Vorteil, daß auf eine aufwendige Kühlung des Mikrowellenresonators auch über der Außenwand (wie sie im zweiten Fall unter Umständen erforderlich ist) verzichtet werden kann.

Im zweiten bzw. dritten Fall ist der das Plasma erzeugende Mikrowellenresonator im Inneren oder außerhalb mindestens eines Wärmereflexionsfilters beweglich angeordnet. Dies hat den Vorteil, daß die Position der Filteranordnung mit Bezug auf das zu beschichtende Rohr konstant bleibt und demzufolge axiale und/oder periphere Asymmetrien in der Energieabgabe durch eine entsprechende Filterauslegung optimal kompensiert werden können. Eine konstante Filterposition vereinfacht gleichzeitig den mechanischen Aufbau und erlaubt das Beschichten bzw. die Bewegung des Mikrowellenresonators über der vollen Länge der Filteranordnung.

Vorzugsweise ist in mindestens einem Bereich der Umkehrpunkte des Mikrowellenresonators eine zusätzliche Wärmequelle angebracht. Damit wird erreicht, daß auch in diesem Bereich -der wegen der notwendigen Bewegungsumkehr von Plasma axial nichtuniform und im Vergleich zu den übrigen Rohrbereichen zu wenig aufgeheizt wird -das zu beschichtende Rohr auf eine ausreichend hohe und uniforme Temperatur gebracht werden kann.

Die zusätzliche Wärmequelle besteht vorzugsweise aus einem elektrisch beheizten Widerstandsofen. Die Verwendung anderer Wärmequellen, wie z.B. die Aufheizung des Rohres durch Laser oder Heißluft, ist ebenfalls möglich, jedoch in der Regel technisch aufwendiger und weniger effektiv.

Die Länge der Wärmequelle entspricht vorzugsweise der des Plasmas. Damit wird erreicht, daß nur die Bereiche des zu beschichtenden Rohres bezüglich ihrer Wärmeenergie-und Temperaturverteilung beeinflußt werden, die vom Plasma bei der Bewegungsumkehr nichtuniform und zu wenig aufgeheizt werden.

Eine weitere bevorzugte Ausführungsform der erfindungsgemäßen Vorrichtung ist dadurch gekennzeichnet, daß die Wärmequelle das Rohr aus elektrisch isolierendem Material umschließt und in peripherer Richtung homogen aufheizt. Dies hat den Vorteil, daß durch die zusätzliche Wärmequelle keine zusätzlichen peripheren Asymmetrien in der Temperaturverteilung auf dem zu beschichtenden Rohr erzeugt werden.

Bei einer bevorzugten Ausführungsform des erfindungsgemäßen Verfahrens wird die Position einer zusätzlichen Wärmequelle in mindestens einem Bereich der Hubumkehr in bezug auf das elektrisch isolierende Rohr während der Hubbewegung des Mikrowellenresonators in den übrigen Bereichen des Rohres konstant gehalten. Damit wird erreicht, daß die Rohrbereiche, die vom Plasma nichtuniform und unzureichend aufgeheizt werden, von der Wärmequelle besonders effektiv geheizt werden, da die Heizleistung der Wärmequelle über der gesamten Zeitdauer für einen Hin-und Rückhub über dem Rohr ortsfest auf die Bereiche der Hubumkehr einwirkt.

Dabei ist es zweckmäßig, die Wärmequelle für die Zeitdauer der Hubumkehr des Mikrowellenresonators in ihrer Position in bezug auf das Rohr aus elektrisch isolierendem Material zu verändern. Dies hat nämlich den Vorteil, daß auch die von der Wärmequelle beheizten Rohrbereiche mit dem Mikrowellenresonator überfahren und damit auch hier eine Abscheidung des elektrisch isolierenden Materials vorgenommen werden kann. Dabei ist es zweckmäßig, daß die Wärmequelle in axialer Richtung um mindestens die Breite des Mikrowellenresonators in Bewegungsrichtung des Mikrowellenresonators verschoben wird. Dies hat den Vorteil, daß die Verschiebung der Wärmequelle über den Resonator selbst vorgenommen werden kann, wobei die Wärmequelle z.B. vom Resonator mechanisch gegen ein elastisches Feder lager verschoben wird und nach erfolgter Hubumkehr wieder ihre vorherige Position über dem Rohr einnimmt.

Die Wärmequelle ist vorzugsweise im Inneren der Wärmereflexionsfilter angeordnet. Dies hat den Vorteil, daß ihre Heizleistung direkt auf das zu beschichtende Rohr einwirkt und -über das umgebende Filter -Abstrahlungsverluste nach außen klein gehalten werden können, was eine besonders effektive lokale Heizung ermöglicht.

Ausführungsbeispiele zur Erläuterung der Erfindung sind in einer Zeichnung dargestellt. In der Zeichnung zeigen.

Fig. 1 eine bewegliche Resonator/Reflektor-Anordnung schematisch im Schnitt,

Fig. 2 eine statische Reflektoranordnung - schematisch im Schnitt und

Fig. 3 eine weitere statische Reflektoranordnung schematisch im Schnitt.

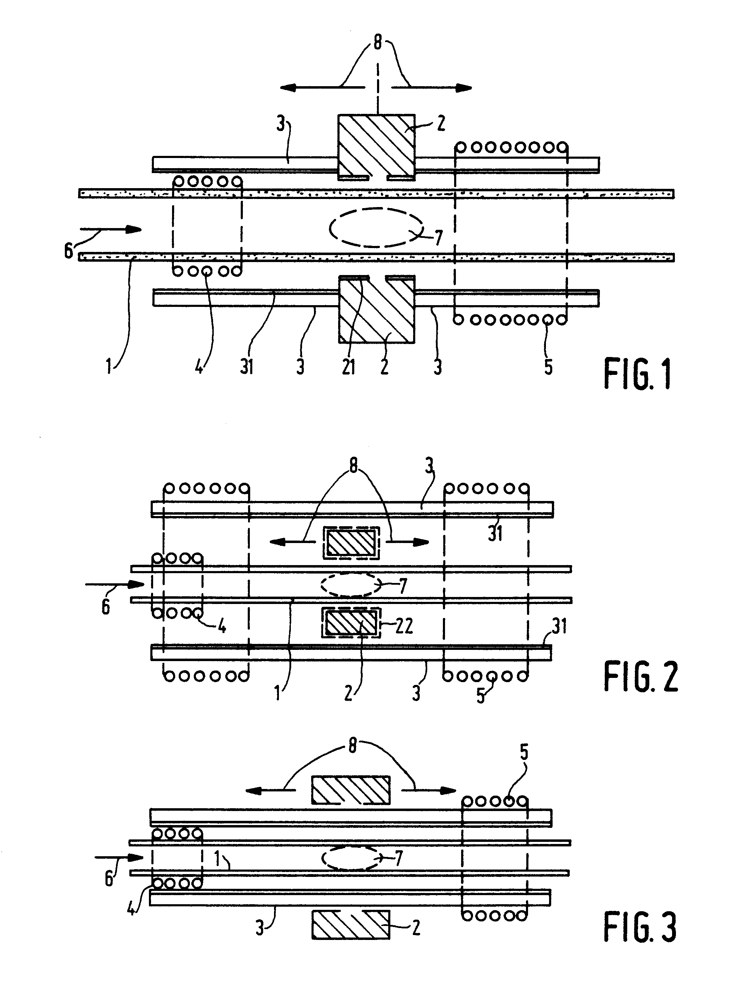

In Fig. 1 ist ein zu beschichtendes Quarzrohr 1 zu beiden Seiten eines Resonators 2 von zylindrischen Wärmereflektoren 3 umgeben, die synchron mit dem Resonator längs des Quarzrohres verschiebbar ist. Die Wärmereflektoren weisen ein wärmereflektierende Schicht 31 auf. Auch die dem Quarzrohr zugewandte Seite des Resonators ist gegebenenfalls mit einer wärmereflektierenden Schicht 21 versehen. Zur Kompensation von Abstrahlungsverlusten an den Rohrenden ist zwischen Wärmereflektor und Quarzrohr gegebenenfalls eine Zusatzheizung 4 vorgesehen. Eine ähnliche Zusatzheizung 5 ist gegebenenfalls auch über der gesamten Länge des Reflektors angeordnet, um bei geringeren Plasmaleistungen die optimale Substrat temperatur einzustellen. Der Reflektor 3 weist gegebenenfalls längs seiner Achse und über seinem Radius einen variablen oder konstanten Reflexionskoeffizienten auf.

Beim Betrieb der Vorrichtung nach Fig. 1 wird ein Gasgemisch in das Quarzrohr 1 eingeleitet, was durch einen Pfeil 6 angedeutet ist. Durch den Resonator 2 wird ein Plasma 7 erzeugt. Die Hin-und Herbewegung des Resonators wird durch Pfeile 8 angedeutet.

Bei der Vorrichtung nach Fig. 2 befinden sich ein Quarzrohr 1 und ein wärmeisolierter und/oder gekühlter Resonator 2 innerhalb eines Wärmereflektors 3. Die Wärmeisolierung bzw. Kühlung ist durch eine gestrichelt gezeichnete Umhüllung 22 angedeutet. Gegebenenfalls sind außen-und innenliegende Zusatzheizungen 4, 5 vorgesehen.

Bei der Vorrichtung nach Fig. 3 ist ein zu beschichtendes Quarzrohr 1 von einem zylindrischen Reflektor 3 umgeben. Die Auslegung der Reflexionseigenschaften ist derart, daß die elektromagnetische Strahlung im Wellenlängenbereich zwischen etwa 1 und 10μm reflektiert, im langwelligen Bereich (Mikrowellen) jedoch weder Reflexion noch Absorption erfolgt. Diese Anordnung gestattet die Verschiebung eines außerhalb des Reflektors angeordneten Resonators 2. Wie in Fig. 1 und 2 ist die Möglichkeit einer Zusatzheizung 4, 5 vorgesehen.

**Ansprüche**

1. Verfahren zum Innenbeschichten eines Rohres aus einem elektrisch isolierenden Material mit einem zweiten elektrisch isolierenden Material durch reaktive Abscheidung des zweiten elektrisch isolierenden Materials aus einem Gasgemisch, das durch das Rohr hindurchgeführt wird, wobei das Rohr thermisch erhitzt und die Abscheidung durch ein in dem Rohr hin-und herbewegtes, durch Mikrowellen erzeugtes Plasma aktiviert wird,

dadurch gekennzeichnet, daß das Rohr zumindest teilweise durch die vom Plasma an die Rohrwand abgegebene Energie erwärmt und auf Reaktionstemperatur gehalten wird, indem die Wärmeverluste des Rohres an die Umgebung durch ein wärmereflektierendes Element auf die Rohrwand zurückgeführt werden.

2. Verfahren nach Anspruch 1,

dadurch gekennzeichnet, daß die Position einer zusätzlichen Wärmequelle zur Erwärmung des Rohres in mindestens einem Bereich der Hubumkehr in bezug auf das Rohr während der Hin-und Herbewegung des Plasmas in den übrigen Bereichen des Rohres konstant gehalten wird.

3. Verfahren nach Anspruch 2,

dadurch gekennzeichnet, daß die Wärmequelle für die Zeitdauer der Hubumkehr des Plasmas in ihrer Position in bezug auf das Rohr verändert wird.

4. Verfahren nach Anspruch 3,

dadurch gekennzeichnet, daß die Wärmequelle in axialer Richtung um mindestens die Breite eines das Plasma erzeugenden Mikrowellenresonators in Bewegungsrichtung des Mikrowellenresonators verschoben wird.

5. Vorrichtung zum Innenbeschichten eines Rohres aus einem elektrisch isolierenden Material mit einem zweiten elektrisch isolierenden Material durch reaktive Abscheidung des zweiten elektrisch isolierenden Materials aus einem Gasgemisch, das durch das Rohr hindurchgeführt wird, wobei die Vorrichtung ein Gaszufuhrsystem zum Zuführen des Gasgemisches zu dem Rohr, einen Mikrowellengenerator und einen Mikrowellenresonator zum Erzeugen und Aufrechterhalten eines Plasmas in dem Gasgemisch in dem Rohr, Mittel zum Hin-und Herbewegen des Plasmas in der Längsrichtung des Rohres und Mittel zum thermischen Erhitzen des Rohres enthält,

dadurch gekennzeichnet, daß die Mittel zum thermischen Erhitzen des Rohres (1) ein wärmereflektierendes Element (3) zum Zurückführen der durch das Plasma (7) entstehenden und vom Rohr abgegebenen Wärme zum Rohr aufweisen.

6. Vorrichtung nach Anspruch 5,

dadurch gekennzeichnet, daß das wärmereflektierende Element aus mindestens einem Wärmereflexionsfilter (3) besteht.

7. Vorrichtung nach Anspruch 6,

dadurch gekennzeichnet, daß das Wärmereflexionsfilter die Form eines mit wärmereflektierenden Materialien beschichteten Rohres (3) aufweist,das konzentrisch zu dem Rohr (1) aus elektrisch isolierendem Material angeordnet ist.

8. Vorrichtung nach Anspruch 7,

dadurch gekennzeichnet, daß die wärmereflektierende Beschichtung (31) über der Rohrlänge und/oder über dem Rohrumfang nichtuniform aufgebracht ist.

9. Vorrichtung nach Ansprüchen 7 oder 8,

dadurch gekennzeichnet, daß mehrere mit wärmereflektierenden Materialien beschichtete Rohre (3) konzentrisch übereinander angebracht und bezüglich ihrer axialen und/oder peripheren Position gegeneinander verschiebbar sind.

10. Vorrichtung nach einem oder mehreren der Ansprüche 6 bis 9,

dadurch gekennzeichnet, daß die Wärmereflexionsfilter (3) beidseitig an dem Mikrowellenresonator (2) angebracht und mit diesem gemeinsam längs des Rohres aus elektrisch isolierendem Material hin und her bewegbar sind.

11. Vorrichtung nach einem oder mehreren der Ansprüche 6 bis 9,

dadurch gekennzeichnet, daß der das Plasma (7) erzeugende Mikrowellenresonator (2) im Inneren oder außerhalb mindestens eines Wärmereflexionsfilters (3) beweglich angeordnet ist.

12. Vorrichtung nach Anspruch 5,

dadurch gekennzeichnet, daß in mindestens einem Bereich der Umkehrpunkte des Mikrowellenresonators (2) eine zusätzliche Wärmequelle (4, 5) angebracht ist.

13. Vorrichtung nach Anspruch 12,

· dadurch gekennzeichnet, daß die Wärmequelle aus einem elektrisch beheizten Widerstandsofen (4, 5) besteht.

14. Vorrichtung nach Anspruch 12,

dadurch gekennzeichnet, daß die Länge der Wärmequelle (4, 5) der des Plasmas (7) entspricht.

15. Vorrichtung nach einem oder mehreren der Ansprüche 12 bis 14,

dadurch gekennzeichnet, daß die Wärmequelle (4, 5) das Rohr (1) aus elektrisch isolierendem Material umschließt und in peripherer Richtung homogen aufheizt.

16. Vorrichtung nach einem oder mehreren der Ansprüche 12 bis 15,

dadurch gekennzeichnet,daß die Wärmequelle (4, 5) im Inneren der Wärmereflexionsfilter (3) angeordnet ist.

FIG.1

FIG.2

FIG.3